# EUROPÄISCHE PATENTSCHRIFT

(11) **EP 1 726 687 B1**
(45) Veröffentlichungstag und Bekanntmachung des Hinweises auf die Patenterteilung: **21.08.2013**
(21) Anmeldenummer: 06008380.5
(22) Anmeldetag: 24.04.2006
(51) Int. Cl.: C23C 14/06, C23C 30/00, C22C 14/00, C22C 30/00

(54) **Beschichtes Werkzeug**
Coated tool
Outil revêtu

(30) Priorität: 29.04.2005 AT 28605 U
(43) Veröffentlichungstag der Anmeldung: 29.11.2006
(73) Patentinhaber: CERATIZIT Austria Gesellschaft m.b.H., 6600 Reutte /Tirol (AT)
(72) Erfinder: Kathrein, Martin, 66600 Reutte (AT); Michotte, Claude, 6700 Arlon (BE); Polcik, Peter, 6600 Reutte (AT)

(56) Entgegenhaltungen:
- EP-A1- 1 018 387
- EP-A2- 1 201 776
- EP-A2- 1 452 621
- WO-A2-2004/059030
- DE-A1- 10 233 222

## Beschreibung

Die Erfindung betrifft ein Werkzeug, bestehend aus einem Grundwerkstoff der Gruppe Hartmetall, Cermet, Hartstoff und Werkzeugstahl und einer zwei- oder mehrlagigen Schicht mit einer Gesamtschichtdicke von 0,5 µm bis 15 µm, wobei eine Schichtlage eine Dicke von 0,0003 - 5,0 µm aufweist.

Hartmetalle, Cermets, Hartstoffe und Werkzeugstähle werden für Werkzeuge eingesetzt, die einer hohen verschleißenden Beanspruchung ausgesetzt sind. Unter Hartmetall versteht man einen Verbundwerkstoff, der aus einer Hartstoffphase und einem metallischen Binder aufgebaut ist. Die Werkstoffgruppe der Cermets umfasst alle Werkstoffe, die aus einer oder mehreren keramischen Phasen und aus einer oder mehreren metallischen Phasen aufgebaut sind. Unter Hartstoffe werden alle Stoffe mit einer Härte von > 1000 HV zusammengefasst. Dies sind Verbindungen von Elementen der IVa bis VIa Gruppe des Periodensystems mit den Elementen Kohlenstoff, Stickstoff, Bor oder Silizium. Jedoch auch Diamant, kubisches Bornitrid, Siliziumkarbid, Sialone, Aluminiumoxid, Aluminiumnitrid und Siliziumnitrid, um die wichtigsten zu nennen, fallen in diese Werkstoffgruppe. Werkzeugstähle sind nach DIN 17 300 Stähle, die durch ihre Anwendung in Werkzeugen definiert sind.

Um die Verschleißfestigkeit zu erhöhen, werden auf dem Grundwerkstoff verschleißfeste Hartstoffschichten auf der Basis von Karbiden, Nitriden, Boriden, Siliziden und Oxiden aufgebracht. Diese Schichten können aus einer oder mehreren Schichtlagen aufgebaut sein und weisen Härten auf, die üblicherweise im Bereich 1500 HV bis 4000 HV liegen. Beispielhaft sei auf Ein- oder Mehrlagenschichten bestehend aus Titannitrid, Titancarbonitrid, Titanaluminiumnitrid (siehe beispielsweise EP A1-1 018 387) oder Aluminiumoxid verwiesen.

Im Beanspruchungsfall umfasst das tribologische System neben dem Werkzeug noch den Verschleiß und Reibung verursachenden Gegenkörper, gegebenenfalls Zwischenstoffe, die einwirkenden Kräfte, den Bewegungsablauf und die Umgebungseinflüsse. Speziell wenn die einwirkenden Kräfte und die Relativgeschwindigkeit zwischen Werkzeug und Gegenkörper hoch sind, kommt es im oberflächlichen Grenzbereich zwischen dem Verschleißteil und dem Gegenkörper zu einem deutlichen Temperaturanstieg. So werden beispielsweise an der Oberfläche eines Zerspanungswerkzeuges Temperaturen von 1.000°C und fallweise darüber gemessen. Die Ursachen dafür sind Verformungs- und Trennarbeit in der Scherzone, Reibung des Spanes an der Spanfläche und Reibung des Werkstückes an der Freifläche. Hartstoffschichten auf der Basis von TiAIN kommen breit zur Verbesserung des Verschleißverhaltens von Werkzeugen zur Anwendung. Der Einfluss unterschiedlicher Al-Gehalte auf die Verbesserung der Abrasions- und Oxidationsbeständigkeit, sowie der Einfluss weiterer Elemente auf die Abrasionsbeständigkeit von, insbesondere über PVD-Verfahren hergestellter Titannitridschichten, wurden untersucht.
So sind in "Thin Solid Films, 343 (1999) p. 242-245" TiAIBN-Schichten beschrieben, die in einem Ar-Plasma bei 450°C hergestellt wurden. Es konnten jedoch keine signifikanten Verbesserungen in der Verschleißbeständigkeit beim Trockenzerspanen erzielt werden.
Aus "Surf. Coat. Technol., 133-134 (2000) 145-151" gehen mittels kathodischer Arc-Verdampfung hergestellte TiAISiN-Schichten mit 3,8 At. % bis 8,2 At.% Si hervor, wobei Härtewerte von 35 bis 45 GPa erreicht wurden.
Weiters kann auch in einer TiAIN-Schicht Ti durch Cr, Hf, Zr oder Nb substituiert werden.
So wird in der WO 2004/059030 eine AICrN-Beschichtung mit verbesserten Verschleißkennwerten beschrieben.

In der EP 0 558 061 wird die teilweise oder vollständige Substitution des Ti im Titan-Nitrid durch die Elemente Hf, Zr, Cr oder Nb beschrieben, wobei derartige Hartstoffschichten über eine metallische Zwischenschicht aus Nb oder Ta mit dem Grundwerkstoff verbunden sind.

In der JP 2003-034859 wird eine verschleißbeständige MeAICrVCN-Beschichtung beschrieben, wobei für Me mindestens eines der Elemente Ti, Nb, W, Ta oder Mo zur Anwendung kommt.

In der EP 1 201 776 wird ein Zahnradfräswerkzeug aus Schnellarbeitsstahl mit einer Multilayerschichtkombination aus TiAlTaN oder TiAlTaCN und TiAlN oder TiAlCN beschrieben, das für die Bearbeitung von niedrig legierten Stählen oder Weichstählen verwendet wird. Die Kombination beider Schichten ergibt eine hohe Standzeit bei geringer Spanverklebeneigung.

Des Weiteren beschreibt die EP-A2-1 201 776 D2 eine Hartstoffschicht, die aus TiAlN und TiAlTaN Schichtlagen besteht.

Die DE 102 33 222 A1 wiederum beschreibt eine Nitrid- oder Karbonitrid-Schicht, die neben Al, Cr oder V enthält. Aus der DE 102 33 222 A1 geht weiters eine Nitrid- oder Karbonitrid-Schicht hervor, die neben Al zumindest ein Element aus der Gruppe Ti, Nb, W, Ta und Mo sowie Cr und/oder V enthält. Eine Verbesserung der Filmhärte und der Verschleißbeständigkeit kann erreicht werden, indem die Al-Konzentration erhöht, sowie: Cr oder V und zumindest ein Element, ausgewählt aus der Gruppe Ti, Nb, W, Tia und Mo zugegeben wird.

Bei hoher Beanspruchung des Werkzeuges, wie dies beispielsweise bei Trocken-Fräsen von legierten Stählen der Fall ist, werden sehr hohe Oberflächentemperaturen in den Kontaktzonen des Werkzeuges, wie etwa der Spanfläche und Freifläche erreicht. Ähnlich hohe Beanspruchungen treten beispielsweise auch im Einzugsbereich eines Verformungswerkzeuges auf. Die Verschleißbeständigkeit der bekannten und zuvor beschriebenen Schichtsysteme ist in solchen Anwendungsfällen, insbesondere wenn keine Kühlschmierstoffe zum Einsatz kommen, bisher nicht zufriedenstellend.

Aufgabe der Erfindung ist daher die Bereitstellung eines Werkzeuges mit hoher Verschleißbeständigkeit bei hoher Temperaturbelastung, wobei der Reibwert im Kontakt mit dem Verschleißkörper möglichst niedrig ist.

Erfindungsgemäß wird diese Aufgabe durch Anspruch 1 gelöst

Die erfindungsgemäße Schicht besteht aus zumindest zwei Schichtlagen. Eine erste Schichtlage weist dabei eine Zusammensetzung von (TiₐAl_{b}Ta_{c})N auf, wobei
a + b + c = 1, 0,3 ≤ b ≤ 0,75 und 0,001 ≤ c ≤ 0,30 betragen. Im Folgenden wird diese Schichtlage als A bezeichnet.

Die zweite Schichtlage weist eine Zusammensetzung (Ti_{d}AlₑTa_{f}M_{g})N auf, mit d + e + f + g = 1, 0,50 ≤ e ≤ 0,70 und 0 ≤ f ≤ 0,25. M bezeichnet dabei ein oder mehrere Elemente der Gruppe Silizium, Vanadium und Bor, wobei der Siliziumgehalt zwischen 0,05 At% und 10 At%, der Vanadiumgehalt zwischen 0,1 At.% und 25 At% und der Bor-Gehalt zwischen 0,005 At.% und 1 At.% betragen. Im Folgenden wird diese Schichtlage als B bezeichnet.

Durch das Zulegieren von Tantal in der Schichtlage A wird eine deutliche Erhöhung der Warmhärte erreicht. Es hat sich dabei gezeigt, dass Tantal den kubisch flächenzentrierten Mischkristall bis zu sehr hohen Temperaturen von etwa 800°C stabilisiert. Bei höheren Temperaturen erfolgt zwar ein Phasenzerfall, wobei kubische Aluminiumnitrid-Domänen ausgeschieden werden. Durch diese Ausscheidung wird ein weiterer Härteanstieg von ca. 10 % bei Temperaturen von etwa 900°C erreicht. Selbst bei einer Beanspruchungstemperatur von 1.100°C wurden nach Glühversuchen im Vakuum noch Härtewerte im Bereich der Schichthärte des Ausgangszustandes gemessen. Tantal als Bestandteil der Schichtlage A erhöht somit die Warmhärte in einem Temperaturbereich der insbesondere bei ungekühlten Verformungsprozessen in der Kontaktzone zwischen der beschichteten Oberfläche und dem Verschleißkörper auftritt. Das Zulegieren von Tantal führt daher im relevanten Temperaturbereich von 700°C bis 1.100°C zu einem optimalen Schutz vor abrasivem Verschleiß, wobei dies in selbst-adaptiver Weise erreicht wird. Tantal in TiAIN bewirkt jedoch bei Temperaturen von 700°C und darüber einen Anstieg des Reibkoeffizienten. Dies wurde sowohl gegen eine inerte Aluminiumoxidkugel als auch gegen einen austenitischen Stahl nachgewiesen. Weiters reicht die Zähigkeit der Schichtlage A für viele Anwendungsfälle nicht aus; beispielsweise sind hier Fräsbearbeitungen und das Hochgeschwindigkeitszerspanen genannt. Die Schichtlage B enthält zumindest ein Element der Gruppe Silizium, Vanadium und Bor. Silizium, Vanadium und Bor wirken reibmindernd bei hohen Temperaturen. Zudem enthält Schichtlage B vorzugsweise weniger Tantal als Schichtlage A, wodurch die Schichtlage B duktiler als die Schichtlage A ist. Durch eine Abfolge von Schichtlage A und Schichtlage B lässt sich die Zähigkeit der Mikrostruktur einstellen, wobei diese derartig günstig beeinflusst werden kann, dass etwa bei Fräsbearbeitungen eine ausreichende Stabilität der Beschichtung gegen Absplitterung gewährleistet ist. Die Verschleißbeständigkeit kann sowohl durch den Tantalgehalt, als auch das Ti/Al-Verhältnis eingestellt werden. Es hat sich dabei herausgestellt, dass in der Schichtlage A in Abhängigkeit vom Tantalgehalt von 0,1 At.% bis 30 At.% der Al-Gehalt von 30 At.% bis 75 At.% eingestellt werden kann. Auch in der Schichtlage B kann das Ti/AI-Verhältnis in Abhängigkeit vom Tantalgehalt, der im Bereich von 0 At.% bis 25 At.% liegen, in einem weiten Bereich gemäß den Angaben in Anspruch 1 gewählt werden. Ein bevorzugter Bereich für Aluminium in der Schichtlage A liegt dabei bei 45 At.% bis 66 At.%. Gehalte von Tantal unter 0,1 At.% erhöhen die Härte in nicht ausreichendem Maße. Bei Ta-Gehalten über 30 At.% tritt ein zu starke Versprödung der Schichtlage A auf. Ein bevorzugter Bereich für Tantal in der Schichtlage A liegt dabei bei 1 At.% bis 25 At.%. In der duktileren Schichtlage B können entsprechend geringere Tantal-Gehalte gewählt werden, wobei Gehalte von 0 At.% bis 25 At.%, bevorzugt 0,2 At.% bis 10 At.%, zur Anwendung kommen. Silizium in der Schichtlage B wirkt sich günstig auf die Oxidationsbeständigkeit aus. Um hier einen ausreichenden Effekt zu erzielen, sind Gehalte von 0,1 At.% vorteilhaft. Bei Gehalten über 10 At.% ergibt sich eine für viele Anwendungen unzulässig hohe Versprödung. Die bevorzugte obere Grenze liegt bei 3 At.%. Es hat sich herausgestellt, dass diese günstigen Gehalte von 0,1 At.% bis 3 At.% in ausreichendem Maße die Reibung zwischen dem Werkzeug und dem Gegenkörper verringern. Vanadium wirkt im Vergleich zu Silizium deutlich weniger festigkeitssteigernd und beeinflusst daher auch die Bruchzähigkeit der Schicht in nicht so hohem Maße. Die Vanadium-Gehalte können daher höher gewählt werden als die Silizium-Gehalte in Schichtlage B.

Umfangreiche Versuche haben gezeigt, dass ein optimaler Vanadium-Gehalt bei 0,1 At.% bis 25 At.%, bevorzugt bei 2 At.% bis 20 At.% liegt. Vanadium wirkt stark reibmindernd, wobei dies auf die Bildung von Magneli-Phasen zurückgeführt werden kann. Der bevorzugte Bereich von Bor in Schichtlage B liegt bei 0,001 At.% bis 0,5 At.%. Bor steigert die Oxidationsbeständigkeit der Schicht durch Verringerung der Diffusionsgeschwindigkeit für weitere Elemente. Bei Gehalten über 1 At.% kommt es zu einer Verringerung der Härte, was auf die Bildung von hexagonalen Phasenbestandteilen zurückzuführen ist. Durch die Verwendung von Viellagenschichten kann die Gefügestruktur der Schicht und damit auch die Bruchzähigkeit in idealer Weise eingestellt werden. Die Anzahl der Schichtlagen kann dabei im Bereich von ca. 10 bis an die 10.000 Schichten und darüber liegen. Eine periodische Abfolge der einzelnen Schichtlagen kann dabei anlagentechnisch einfacher hergestellt werden. Bei zwei unterschiedlichen Schichtlagen ergibt sich damit die Abfolge A,B,A,B,A,B ...

Kommt eine dritte Schichtlage C zur Anwendung ergibt sich daraus die Abfolge A,B,C,A,B,C,A,B,C ...

In analoger Weise ergeben sich die entsprechenden Abfolgen bei vier bzw. mehr Schichtlagen unterschiedlicher Zusammensetzung. Schichtlagen unterschiedlicher Zusammensetzung weisen auch unterschiedliche Keimbildungsraten bzw. unterschiedliche Keimwachstumsgeschwindigkeiten auf. Damit zeigen die einzelnen Schichtlagen typischerweise auch unterschiedliche Dicken. Ein optimales Bruchzähigkeits- / Härte Verhältnis kann dann eingestellt werden, wenn die einzelnen Schichtlagen überwiegend eine kubische Struktur aufweisen, da die kubische im Vergleich zur hexagonalen Phase eine deutlich verschleißbeständigere Struktur ist. Geringe Anteile an zum Beispiel röntgenamorphen Gefügebestandteilen, die zwischen den kubischen angeordnet sind, erhöhen die Bruchzähigkeit der Schicht. Zur Verbesserung der Schichthaftung ist es vorteilhaft, dass die mit dem Grundwerkstoff in Kontakt stehende Schichtlage aus Titannitrid besteht. Die günstigste Kombination Schicht und Grundwerkstoff wird bei Verwendung von Hartmetall als Grundwerkstoff erzielt.
Hervorragende Standzeitwerte können bei Verwendung des beschichteten Werkzeuges als Schneidwerkzeug erzielt werden. Eine typische Verwendung als Schneidwerkzeug sind dabei Vollhartmetall-Fräwswerkzeuge und Wendeschneidplatten. Jedoch auch bei Umformwerkzeugen lassen sich die erfinderischen Vorteile realisieren.
Für das Aufbringen der Beschichtung können unterschiedliche Beschichtungsverfahren zur Anwendung kommen. Eine günstige Verfahrenstechnik ist dabei das PVD-Verfahren im Arc-Verdampfungs- oder Sputter-Modus, unter Verwendung von Ein- oder Mehrkomponenten-Targets. Die Targets zur Herstellung der Schichtlage A weisen dabei einen AluminiumGehalt von 30 At.% bis 75 At.% und einen Tantal-Gehalt von 0,1 At.% bis 30 At.% auf, wobei der Rest aus Titan besteht.
Targets zur Herstellung der Schichtlage B bestehen aus 50 At.% bis 70 At.% Aluminium, 0 bis 25 At.% Tantal und zumindest einem Element der Gruppe Silizium, Vanadium, Bor und Rest Titan, wobei im Falle von Silizium der Gehalt bei 0,05 At.% bis 10 At.%, im Falle von Vanadium der Gehalt bei 0,1 At.% bis 25 At.% und im Falle von Bor der Gehalt bei 0,005 At.% bis 1 At.% liegt.

Alternativ zu den PVD-Verfahren lassen sich auch verschiedene CVD-Verfahren zur Umsetzung der vorliegenden Erfindung nutzen. Beispielsweise lassen sich durch Plasma unterstütze CVD-Verfahren oder CVD-Verfahren mit metallorganischen Precursoren (MOCVD) die erfindungsgemäße Beschichtung herstellen.

Die vorliegende Erfindung wird im Nachfolgenden durch Ausführungsbeispiele näher beschrieben.

Zweilagige TiAlTaN/TiAlTaMeN-Schichten wurden mittels einer konventionellen PVD-Industrieanlage mit Arc-Verdampfung von pulvermetallurgisch hergestellten Targets in einer N₂-Ar Atmosphäre auf Wendeschneidplatten aus Hartmetall aufgebracht. Die Gehalte der Legierungselemente in der Schicht stehen in diesem Prozess unter Berücksichtigung der Prozessfahrweise in guter Übereinstimmung mit den Gehalten der Elemente in den verwendeten Targets. In den Tabelle 1 - 5 sind die Zusammensetzungen der verwendeten Targets für den Schichtherstellprozess angegeben. Vier Quellen bzw. Targetpositionen wurden verwendet. Es wurden jeweils zwei gegenüberliegende und in der Höhe versetzte Positionen mit Targets gleicher Zusammensetzung verwendet. Zum Zweck der Vergleichbarkeit wurde ein identes Beschichtungsprogramm auch für die Herstellung der Referenzproben - welche dem Stand der Technik entsprechen - verwendet. Der Probeneinbau und die Belegung der Prozesskammer wurden für alle Proben gleich gewählt.

Für vergleichende Standzeitversuche wurden folgende Parameter verwendet: Wendeschneidplatte: SEKN 1203AF SN aus S40T
Zerspanter Werkstoff: 42CrMo4
Zerspanungsbedingungen: Trockenzerspanung
Zerspanungsparameter: v_{c} = 230 m/min, f = 0.30 mm/U, ap = 2.0 mm, aₑ = 96 mm

### Beispiel 1

Beispiel 1 zeigt anhand einer Viellagenschicht bestehend aus einer periodisch abwechselnden Folge von Schicht 1 und 2 (Probe B 2a) bzw. Schicht 1 b und 2 (Probe B 2b) den Einfluss der Variation des Tantal-Gehaltes bei gleich bleibendem Verhältnis Al/Ti (Al/Ti = 2) in der 1. Schichtlage (1 a, 1 b) und jeweils gleich bleibender Zusammensetzung in der 2. Schichtlage (siehe Tabelle 1).

**Tabelle 1**

| | | | | Ti [At.%]* | Al [At.%]* | Ta [At.%]* | V [At.%]* |
|---|---|---|---|---|---|---|---|
| Referenzprobe | Stand der Technik | Einlagige Schicht | TiAIN | 50 | 50 | | |
| B 2a | Erfindungsgemäß | Schichtlage 1a | TiAlTaN | 33.00 | 66.00 | 1.00 | |
| | | Schichtlage 2 | TiAITaVN | 49.80 | 49.80 | 0.20 | 0.20 |
| | | | | | | | |
| B 2b | Erfindungsgemäß | Schichtlage 1b | TiAITaN | 31.50 | 63.50 | 5.00 | |
| | | Schichtlage 2 | TiAlTaVN | 49.80 | 49.80 | 0.20 | 0.20 |

| | | | | | | | |
|---|---|---|---|---|---|---|---|
| (* bezogen auf metallischen Anteil) | | | | | | | |

Die Standzeitverbesserung mit der Beschichtung B 2a gegenüber der Referenzprobe beträgt 78 %. Mit der Beschichtung B 2b konnte eine Standzeitverdoppelung erzielt werden.

### Beispiel 2

Beispiel 2 zeigt anhand einer Viellagenschicht bestehend aus einer periodisch abwechselnden Folge von Schicht 1 b und 2 (Probe B 3a) bzw. Schicht 1 c und 2 (Probe B 2b) den Einfluss des Al/Ti-Verhältnisses (Al/Ti = 1,5; Al/Ti = 2) bei gleich bleibendem Tantalgehalt in der 1. Schichtlage und jeweils gleich bleibender Zusammensetzung in der 2. Schichtlage (siehe Tabelle 2).

**Tabelle 2**

| | | | | Ti [At.%]* | Al [At.%]* | Ta [At.%]* | V [At.%]* |
|---|---|---|---|---|---|---|---|
| Referenzprobe | Stand der Technik | Einlagige Schicht | TiAIN | 50 | 50 | | |
| B 3a | Erfindungsgemäß | Schichtlage 1b | TiAITaN | 38.00 | 57.00 | 5.00 | |
| | | Schichtlage 2 | TiAlTaVN | 49.80 | 49.80 | 0.20 | 0.20 |
| | | | | | | | |
| B 2b | Erfindungsgemäß | Schichtlage 1c | TiAlTaN | 31.50 | 63.50 | 5.00 | |
| | | Schichtlage 2 | TiAlTaVN | 49.80 | 49.80 | 0.20 | 0.20 |

| | | | | | | | |
|---|---|---|---|---|---|---|---|
| (* bezogen auf metallischen Anteil) | | | | | | | |

Es konnte damit sowohl bei Beschichtung B 3a und B 2b eine Standzeitverbesserung gegenüber der Referenzprobe erzielet werden, wobei diese bei B 3a bei 84 % liegt. Zudem zeigen diese Versuche den Einfluss des Al/Ti-Verhältnisses bei konstantem Tantal-Gehalt.

### Beispiel 3

In Beispiel 3 wird der Einfluss von Bor auf das Standzeitverhalten gezeigt (siehe Tabelle 3).

**Tabelle 3**

| | | | | Ti [At.%]* | Al [At.%]* | Ta [At.%]* | B [At.%]* |
|---|---|---|---|---|---|---|---|
| Referenzprobe | Stand der Technik | Einlagige Schicht | TiAIN | 50 | 50 | | |
| B 4 | Erfindungsgemäß | Schichtlage 1 | TiAlTaN | 49.50 | 49.50 | 1.00 | |
| | | Schichtlage 2 | TiAITaBN | 32.83 | 65.67 | 1.00 | 0.50 |

| | | | | | | | |
|---|---|---|---|---|---|---|---|
| (* bezogen auf metallischen Anteil) | | | | | | | |

Die Standzeitverbesserung mit der Beschichtung B 4 gegenüber der Referenzprobe beträgt 42 %.

### Beispiel 4

In Beispiel 4 wird der Einfluss von Silizium auf das Standzeitverhalten gezeigt (siehe Tabelle 4).

**Tabelle 4**

| | | | | Ti [At.%]* | Al [At.%]* | Ta [At.%]* | Si [At.%]* |
|---|---|---|---|---|---|---|---|
| Referenzprobe | Stand der Technik | Einlagige Schicht | TiAlN | 50 | 50 | | |
| B 5 | Erfindungsgemäß | Schichtlage 1 | TiAlTaN | 49.50 | 49.50 | 1.00 | |
| | | Schichtlage 2 | TiAITaSiN | 38.00 | 55.00 | 5.00 | 2.00 |

| | | | | | | | |
|---|---|---|---|---|---|---|---|
| (* bezogen auf metallischen Anteil) | | | | | | | |

Die Standzeitverbesserung mit der Beschichtung B 5 gegenüber der Referenzprobe beträgt 91 %.

### Beispiel 5

In Beispiel 5 wird der Einfluss von Vanadium auf das Standzeitverhalten gezeigt (siehe Tabelle 5).

**Tabelle 5**

| | | | | Ti [At.%]* | Al [At.%]* | Ta [At.%]* | V [At.%]* |
|---|---|---|---|---|---|---|---|
| Referenzprobe | Stand der Technik | Einlagige Schicht | TiAIN | 50 | 50 | | |
| B 6 | Erfindungsgemäß | Schichtlage 1 | TiAlTaN | 49.50 | 49.50 | 1.00 | |
| | | Schichtlage 2 | TiAlTaVN | 16.50 | 66.00 | 1.00 | 16.50 |

| | | | | | | | |
|---|---|---|---|---|---|---|---|
| (* bezogen auf metallischen Anteil) | | | | | | | |

Die Standzeitverbesserung mit der Beschichtung B 6 gegenüber der Referenzprobe beträgt 250 %.

## Patentansprüche

1. Werkzeug, bestehend aus einem Grundwerkstoff der Gruppe Hartmetall, Cermet, Hartstoff und Werkzeugstahl und einer zwei- oder mehrlagigen Schicht mit einer Gesamtschichtdicke von 0,5 µm bis 15 µm, wobei eine Schichtlage eine Dicke von 0,0003 - 5,0 µm aufweist,
**dadurch gekennzeichnet,**
**dass** zumindest eine Schichtlage die Zusammensetzung (TiₐAl_{b}Ta_{c})N mit a + b + c = 1 aufweist, wobei
0,3 ≤ b ≤ 0,75; 0,001 ≤ c ≤ 0,30
und zumindest eine weitere Schichtlage die Zusammensetzung (Ti_{d}AlₑTa_{f}M_{g})N
mit d + e + f + g = 1 aufweist, wobei
0,50 ≤ e ≤ 0,70;
0 ≤ f ≤ 0,25; und
wobei M ein oder mehrere Elemente der Gruppe Si, V, B ist, mit
für Si: 0,0005 s g ≤ 0,10;
für V: 0,001 ≤ g ≤ 0,25 und
für B: 0,00005 ≤ g ≤ 0,01.

2. Werkzeug nach Anspruch 1, **dadurch gekennzeichnet, dass** f < c ist.

3. Werkzeug nach Anspruch 1 oder 2, **dadurch gekennzeichnet, dass** 0,01 ≤ c ≤ 0,25.

4. Werkzeug nach einem der Ansprüche 1 bis 3, **dadurch gekennzeichnet, dass**
0,001 ≤ f ≤ 0,20.

5. Werkzeug nach Anspruch 4, **dadurch gekennzeichnet, dass** 0,002 ≤ f ≤ 0,10.

6. Werkzeug nach einem der Ansprüche 1 bis 5, **dadurch gekennzeichnet, dass**
M Silizium ist, mit 0,001 ≤ g ≤ 0,03.

7. Werkzeug nach einem der Ansprüche 1 bis 5, **dadurch gekennzeichnet, dass**
M Vanadium ist, mit 0,10 ≤ g ≤ 0,20.

8. Werkzeug nach einem der Ansprüche 1 bis 5, **dadurch gekennzeichnet, dass**
M Bor ist, mit 0.0001 ≤ g ≤ 0,005.

9. Werkzeug nach einem der Ansprüche 1 bis 8, **dadurch gekennzeichnet, dass** sich Schichtlagen unterschiedlicher Zusammensetzung periodisch abwechseln.

10. Werkzeug nach einem der Ansprüche 1 bis 9, **dadurch gekennzeichnet, dass** die einzelnen Schichtlagen unterschiedliche Dicke aufweisen.

11. Werkzeug nach einem der Ansprüche 1 bis 10, **dadurch gekennzeichnet, dass** die einzelnen Schichtlagen überwiegend eine kubische Struktur aufweisen.

12. Werkzeug nach Anspruch 11, **dadurch gekennzeichnet, dass** noch geringe Mengen an röntgenamorphen Gefügebestandteilen vorhanden sind.

13. Werkzeug nach einem der Ansprüche 1 bis 12, **dadurch gekennzeichnet, dass** die mit dem Grundwerkstoff in Kontakt stehende Schichtlage Titannitrid ist.

14. Werkzeug nach einem der Ansprüche 1 bis 13, **dadurch gekennzeichnet, dass** die oberste Schicht C als reibmindernden Bestandteil enthält.

15. Werkzeug nach einem der Ansprüche 1 bis 14, **dadurch gekennzeichnet, dass** die oberste Schicht eine metallische Schicht ist.

16. Werkzeug nach einem der Ansprüche 1 bis 14, **dadurch gekennzeichnet, dass** die oberste Schicht eine oxidische Schicht ist

17. Werkzeug nach einem der Ansprüche 1 bis 16, **dadurch gekennzeichnet, dass** der Grundwerkstoff Hartmetall ist.

18. Werkzeug nach einem der Ansprüche 1 bis 17, **dadurch gekennzeichnet, dass** das Werkzeug ein Schneidwerkzeug ist.

19. Werkzeug nach Anspruch 18, **dadurch gekennzeichnet, dass** das Schneidwerkzeug eine Wendeschneidplatte ist.

20. Werkzeug nach einem der Ansprüche 1 bis 17, **dadurch gekennzeichnet, dass** das Werkzeug ein Umformwerkzeug ist.

21. Werkzeug nach einem der Ansprüche 1 bis 20, **dadurch gekennzeichnet, dass** die Schicht mittels CVD Verfahren aufgebracht ist.

22. Werkzeug nach einem der Ansprüche 1 bis 20, **dadurch gekennzeichnet, dass** die Schicht mittels PVD-Verfahren aufgebracht ist.

## Claims

1. Tool, consisting of a base material selected from the group consisting of cemented carbide, cermet, hard material and tool steel and a coating comprising two or more layers with a total coating thickness of from
0.5 µm to 15 µm, a coating layer having a thickness of from 0.0003-5.0 µm,
**characterized**
**in that** at least one coating layer has the composition (TiₐAl_{b}Ta_{c})N
with a + b + c = 1,
0.3 ≤ b ≤ 0.75;
0.001 ≤ c ≤ 0.30
and at least one further coating layer having the composition (Ti_{d}AlₑTa_{f}M_{g})N
with d + e + f + g = 1,
0.50 ≤ e ≤ 0.70;
0 ≤ f ≤ 0.25; and
M being one or more elements selected from the group consisting of Si, V, B, with
for Si: 0.0005 ≤ g ≤ 0.10;
for V: 0.001 ≤ g ≤ 0.25 and
for B: 0.00005 ≤ g ≤ 0.01.

2. Tool according to Claim 1, **characterized in that** f < c.

3. Tool according to Claim 1 or 2, **characterized in that** 0.01 ≤ c ≤ 0.25.

4. Tool according to one of Claims 1 to 3, **characterized in that** 0.001 ≤ f ≤ 0.20.

5. Tool according to Claim 4, **characterized in that** 0.002 ≤ f ≤ 0.10.

6. Tool according to one of Claims 1 to 5, **characterized in that** M is silicon,
with 0.001 ≤ g ≤ 0.03.

7. Tool according to one of Claims 1 to 5, **characterized in that** M is vanadium,
with 0.10 ≤ g ≤ 0.20.

8. Tool according to one of Claims 1 to 5, **characterized in that** M is boron,
with 0.0001 ≤ g ≤ 0.005.

9. Tool according to one of Claims 1 to 8, **characterized in that** coating layers of different compositions alternate periodically.

10. Tool according to one of Claims 1 to 9, **characterized in that** the individual coating layers have different thicknesses.

11. Tool according to one of Claims 1 to 10, **characterized in that** the individual coating layers have predominantly a cubic structure..

12. Tool according to Claim 11, **characterized in that** small quantities of radiologically amorphous microstructural constituents are still present.

13. Tool according to one of Claims 1 to 12, **characterized in that** the coating layer which is in contact with the base material is titanium nitride.

14. Tool according to one of Claims 1 to 13, **characterized in that** the top layer contains C as a friction-reducing constituent.

15. Tool according to one of Claims 1 to 14, **characterized in that** the top layer is a metallic layer.

16. Tool according to one of Claims 1 to 14, **characterized in that** the top layer is an oxidic layer.

17. Tool according to one of Claims 1 to 16, **characterized in that** the base material is cemented carbide.

18. Tool according to one of Claims 1 to 17, **characterized in that** the tool is a cutting tool.

19. Tool according to Claim 18, **characterized in that** the cutting tool is a disposable cutting tool tip.

20. Tool according to one of Claims 1 to 17, **characterized in that** the tool is a shaping tool.

21. Tool according to one of Claims 1 to 20, **characterized in that** the coating is applied by means of CVD processes.

22. Tool according to one of Claims 1 to 20, **characterized in that** the coating is applied by means of PVD processes.

## Revendications

1. Outil composé d'un matériau de base du groupe des métaux durs, cermets, matières dures et aciers à outils, et d'un revêtement bicouche ou multicouche d'une épaisseur totale comprise entre 0,5 µm et 15 µm, dans lequel une couche présente une épaisseur comprise entre 0,0003 µm et 5,0 µm, **caractérisé en ce qu'**au moins une couche du revêtement présente une composition de (TiₐAl_{b}Ta_{c})N dans laquelle a + b + c = 1 , tandis que
0,3 ≤ b ≤ 0,75 ;
0,001 ≤ c ≤ 0,30
et **en ce qu'**au moins une couche supplémentaire présente une composition de (Ti_{d}AlₑTa_{f}M_{g})N dans laquelle
d + e + f + h = 1, tandis que
0,50 ≤ e ≤ 0,70 ;
0 ≤ f ≤ 0,25
et que M est un élément ou une pluralité d'éléments du groupe Si, V, B dans lequel,
pour Si : 0,0005 ≤ g ≤ 0,10
pour V : 0,001 ≤ g ≤ 0,25
et pour B : 0,00005 ≤ g ≤ 0,01.

2. Outil selon la revendication 1, **caractérisé en ce que** f < c.

3. Outil selon la revendication 1 ou 2, **caractérisé en ce que** 0,01 ≤ c ≤ 0,25.

4. Outil selon l'une quelconque des revendications 1 à 3, **caractérisé en ce que** 0,001 ≤ f ≤ 0,20.

5. Outil selon la revendication 4, **caractérisé en ce que** 0,002 ≤ f ≤ 0,10.

6. Outil selon l'une quelconque des revendications 1 à 5, **caractérisé en ce que** M est du silicium dans lequel 0,001 ≤ g ≤ 0,03.

7. Outil selon l'une quelconque des revendications 1 à 5, **caractérisé en ce que** M est du vanadium dans lequel 0,10 ≤ g ≤ 0,20.

8. Outil selon l'une quelconque des revendications 1 à 5, **caractérisé en ce que** M est du bore, dans lequel 0,0001 ≤ g ≤ 0,005.

9. Outil selon l'une quelconque des revendications 1 à 8, **caractérisé en ce que** des couches de revêtement de composition différente sont disposées en alternance périodique.

10. Outil selon l'une quelconque des revendications 1 à 9, **caractérisé en ce que** les couches individuelles du revêtement présentent des épaisseurs différentes.

11. Outil selon l'une quelconque des revendications 1 à 10, **caractérisé en ce que** les couches individuelles du revêtement présentent une structure cubique.

12. Outil selon la revendication 11, **caractérisé par** la présence, en outre, de faibles quantités de constituants structurels amorphes aux rayons X.

13. Outil selon l'une quelconque des revendications 1 à 12, **caractérisé en ce que** la couche de revêtement en contact avec le matériau de base est en nitrure de titane.

14. Outil selon l'une quelconque des revendications 1 à 13, **caractérisé en ce que** la couche de surface contient C comme composant diminuant la friction.

15. Outil selon l'une quelconque des revendications 1 à 14, **caractérisé en ce que** la couche de surface est une couche métallique.

16. Outil selon l'une quelconque des revendications 1 à 14, **caractérisé en ce que** la couche de surface est une couche d'oxydation.

17. Outil selon l'une quelconque des revendications 1 à 16, **caractérisé en ce que** le matériau de base est un métal dur.

18. Outil selon l'une quelconque des revendications 1 à 17, **caractérisé en ce que** ledit outil est un outil de coupe.

19. Outil selon la revendication 18, **caractérisé en ce que** ledit outil de coupe est une plaquette de coupe amovible.

20. Outil selon l'une quelconque des revendications 1 à 17, **caractérisé en ce que** ledit outil est un outil de façonnage.

21. Outil selon l'une quelconque des revendications 1 à 20, **caractérisé en ce que** le revêtement est appliqué par procédé CVD.

22. Outil selon l'une quelconque des revendications 1 à 20, **caractérisé en ce que** le revêtement est appliqué par procédé PVD.
